# EUROPEAN PATENT SPECIFICATION

(11) **EP 2 823 725 B1**
(45) Date of publication and mention of the grant of the patent: **14.09.2016**
(21) Application number: 14176329.2
(22) Date of filing: 09.07.2014
(51) Int. Cl.: H04B 1/3888, H05K 7/20

(54) **Protective cover for a hand-held electronic device**
Schutzabdeckung für eine tragbare elektronische Vorrichtung
Couvercle de protection pour un dispositif électronique portable

(30) Priority: 11.07.2013 CN 201310292281
(43) Date of publication of application: 14.01.2015
(73) Proprietor: Sunon Electronics (Foshan) Co., Ltd., Foshan City (CN)
(72) Inventor: Li, Ming-Tsung, Kaohsiung, Taiwan, R.O.C. (TW); Lin, Shih-Hang Lin, Kaohsiung, Taiwan (R.O.C.) (TW)
(74) Representative: Louis Pöhlau Lohrentz

(56) References cited:
- US-A- 5 230 016
- US-A1- 2010 270 188

## Description

### BACKGROUND OF THE INVENTION

### 1. Field of the Invention

The present invention relates to a protective cover for a hand-held electronic device and, more particularly, to a protective cover with a cooling function for a hand-held electronic device.

### 2. Description of the Related Art

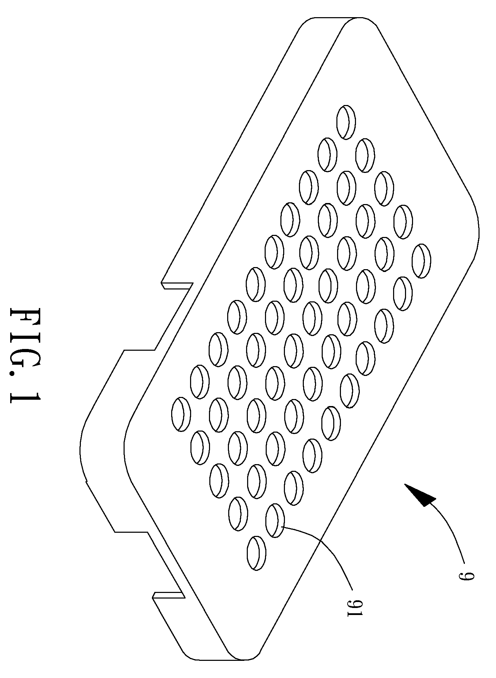

With reference to FIG. 1, a conventional protective cover 9 for a hand-held electronic device generally includes an inner, protective layer on an inner face thereof and an outer, ornamental layer on an outer face thereof. When the protective cover 9 is mounted to an outer side of a hand-held electronic device, the inner, protective layer prevents the hand-held electronic device from scratch during normal use and provides protection if the hand-held electronic device falls by accident or is impacted, reducing breakage and damage of the screen and reducing deformation of the casing of the hand-held electronic device. Furthermore, the outer, ornamental layer of the protective cover 9 can include multi-style patterns to provide an ornamental effect for stimulating the purchase intention of the consumers. Furthermore, the protective cover 9 can include a plurality of circular holes 91 to provide a three-dimensional touch effect in cooperation with the outer, ornamental layer, enhancing the product value. An example of such a protective cover 9 is disclosed in Taiwan Utility Model No. M452536 entitled "PROTECTIVE COVER FOR A MOBILE PHONE".

Taiwan Utility Model No. M451861 entitled "PROTECTIVE COVER", Taiwan Utility Model No. M453334 entitled "IMPROVED STRUCTURE OF A PROTECTIVE CASING FOR A MOBILE PHONE", Taiwan Utility Model No. M453329 entitled "PROTECTIVE COVER FOR A MOBILE PHONE", and Taiwan Utility Model No. M453300 entitled "PROTECTIVE CASING WITH A SOUND OPTIMIZING EFFECT FOR A MOBILE PHONE" disclose different conventional protective covers for hand-held electronic devices. In addition to protection and ornamentation, these conventional protective covers also provide additional functions including allowing accommodation of cards, providing a sound optimization effect, and allowing easy reading by three-dimensional support.

The US Patent Application US 2010/0270188 A1 discloses a computer carrying, cooling and support device for a portable electronic unit having a base portion, at least one angled side portion disposed at an acute angle relative to the base portion, and an integrated cooling fan, wherein the cooling fan is configured to form an elongated cooling air channel between its base portion, its at least one angled side portion, and a bottom surface of the portable electronic unit.

In response to the recent developing trend of the mobile operation industry in high efficiency, manufacturers actively research products with features of high clock rate and multi-task for the purposes of increasing the market competitiveness, which lead to an increase in the operating temperature of the hand-held electronic devices. Furthermore, the need of miniaturization of products compresses the cooling space of the electronic elements, resulting in overheating of the hand-held electronic devices during operation. The cooling efficiency of a hand-held electronic device is reduced if the hand-held electronic device is covered by a protective cover, resulting in unstable operation and adversely affecting the reliability of the hand-held electronic device. The performances of the hand-held electronic device degrade such that the desired performances can not be provided and even causes malfunction.

Use of any of the above conventional protective covers will adversely affect the cooling efficiency of the hand-held electronic device in operation. However, the protective covers are necessary for protecting the hand-held electronic devices to reduce damage, causing a dilemma to the user. Although the circular holes 91 of the protective cover 9 can act as air passages to allow hot air currents to flow therethrough to the outside, the heat sources (such as the cells, the antenna, and the circuit board) are generally located in a specific area such that the heat generated by the heat sources accumulate in the specific area. The passive cooling rate provided by the circular holes 91 for relieving the hot air currents is far slower than the heat generating rate of the heat sources. Thus, the heat energy generated during operation of the hand-held electronic device still accumulate in the specific area and continuously damage the reliability, performances, and service life of the hand-held electronic device.

Thus, improvement to the conventional protective covers for hand-held electronic devices is required.

### SUMMARY OF THE INVENTION

An objective of the present invention is to provide a protective cover including a cooling module providing an auxiliary cooling effect to increase the cooling efficiency of a hand-held electronic device during operation.

Another objective of the present invention is to provide a protective cover using a flow guiding portion of the cooling module to direct the air currents blown from a cooling fan towards the hand-held electronic device, assuring an ideal cooling effect of the protective cover.

A further objective of the present invention is to provide a protective cover using a controller and a cell to drive the cooling fan, and the air currents blown from the cooling fan can discharge the heat energy generated by the controller and the cell, reducing the working temperature of the hand-held electronic device.

The present invention fulfills the above objectives by providing a protective cover for a hand-held electronic device including a base having an inner face and an outer face opposite to the inner face. The base further includes at least one air guiding hole extending from the inner face through the outer face. The base further includes a periphery extending between the inner face and the outer face. A positioning member is provided along the periphery of the base. The positioning member and the base together define a receiving space. A cooling module is mounted in the receiving space. The cooling module includes a cooling fan and a flow guiding portion. The cooling fan and the flow guiding portion are fixed to the inner face of the base. The cooling fan includes an air outlet adjoining the flow guiding portion. The flow guiding portion includes a flow guiding face having at least one non-parallel face at a non-parallel angle to the inner face.

The non-parallel face can be a slant at an acute angle to the inner face, or an arcuate, curved face.

The non-parallel face can include a first edge adjoining the air outlet and a second edge distant from the air outlet. The non-parallel face extends from the first edge to the second edge. A spacing between the first edge and the inner face is smaller than a spacing between the second edge and the inner face.

The flow guiding portion further includes at least one spoiler located on the flow guiding face.

The cooling fan can be aligned with or located adjacent to the at least one air guiding hole of the base.

The positioning member can include at least one air discharge hole intercommunicating the receiving space with the outside.

The cooling fan can be a centrifugal fan. The cooling fan includes a main air inlet in an axial direction thereof. The main air inlet is aligned with and faces the at least one air guiding hole of the base. The air outlet of the cooling fan is located in a radial direction of the cooling fan perpendicular to the axial direction. The air outlet faces the at least one air discharge hole of the positioning member.

The cooling module can further include a controller and a cell. The controller and the cell are fixed to the inner face of the base. The controller is electrically connected to the cooling fan and the cell.

A compartment can be defined between the flow guiding portion and the inner face, and the controller and the cell are received in the compartment.

The flow guiding face of the flow guiding portion can further include at least two through-holes extending through the flow guiding face and intercommunicating with the compartment. In an embodiment, the least two through-holes includes two through-holes. One of the two through-holes is aligned with the air outlet of the cooling fan, and the other through-hole is aligned with the at least one air discharge hole of the positioning member.

The cell can be a secondary cell.

The receiving space can include an electronic device chamber and a fan chamber. The positioning member includes an inner surface having a shoulder extending in a first plane. The positioning member further includes a free end edge extending in a second plane. The electronic device chamber is defined between the first plane and the second plane. The cooling module is received in the fan chamber. The fan chamber and the electronic device chamber overlap in the axial direction of the cooling fan.

The protective cover can further include a spacer plate abutting the shoulder to cover the cooling fan and the controller of the cooling module.

The cooling fan can further include an auxiliary air inlet in the axial direction. The auxiliary air inlet is aligned with the main air inlet in the axial direction.

The spacer plate can include at least one through-hole extending in the axial direction of the cooling fan and aligned with the auxiliary air inlet.

Thus, the protective cover for a hand-held electronic device includes a cooling fan to provide an auxiliary cooling function to increase the cooling efficiency of the hand-held electronic device in operation. Furthermore, the protective cover includes a flow guiding portion to guide the air currents blown out by the cooling fan to directly flow towards the hand-held electronic device, assuring an ideal cooling effect of the protective cover. Furthermore, the air currents blown out by the cooling fan can also discharge the heat generated by the controller and the cell driving the cooling fan, further reducing the operating temperature of the hand-held electronic device.

The present invention will become clearer in light of the following detailed description of illustrative embodiments of this invention described in connection with the drawings.

### BRIEF DESCRIPTION OF THE DRAWINGS

The illustrative embodiments may best be described by reference to the accompanying drawings where:
FIG. 1 is a perspective view of a conventional protective cover for a mobile phone.
FIG. 2 is an exploded, perspective view of a protective cover for a mobile phone
FIG. 3 is a top view of the protective cover
FIG. 4 is cross sectional view of the protective cover and a hand-held electronic device to be coupled to the protective cover, taken from line 4-4 in FIG. 3.
FIG. 5 is a cross sectional view of the protective cover and the hand-held electronic device, illustrating a cooling function of the protective cover.
FIG. 6 is an exploded, perspective view of a protective cover according to the present invention.
FIG. 7 is a cross sectional view of the protective cover according to the present invention, illustrating a cooling function of the protective cover and the hand-held electronic device.
FIG. 8 is an enlarged view of a portion of the protective cover according to the present invention and the hand-held electronic device of FIG. 7.

All figures are drawn for ease of explanation of the basic teachings of the present invention only; the extensions of the figures with respect to number, position, relationship, and dimensions of the parts to form the preferred embodiments will be explained or will be within the skill of the art after the following teachings of the present invention have been read and understood. Further, the exact dimensions and dimensional proportions to conform to specific force, weight, strength, and similar requirements will likewise be within the skill of the art after the following teachings of the present invention have been read and understood.

### DETAILED DESCRIPTION OF THE INVENTION

A protective cover according to the present invention is provided for a hand-held electronic device, such as a mobile phone, a tablet computer, a hand-held game console, a multimedia player, a digital camera, a personal digital assistant, or a satellite navigator. The protective cover is particularly useful for mobiles and tablet computers. Embodiments of the protective covers used on a mobile phone will now be set forth without any limiting purposes.

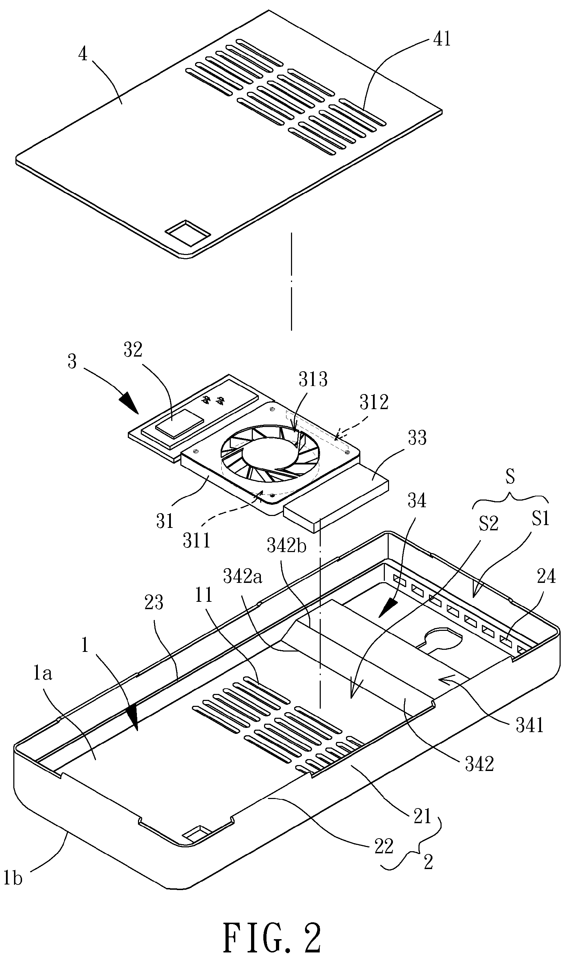

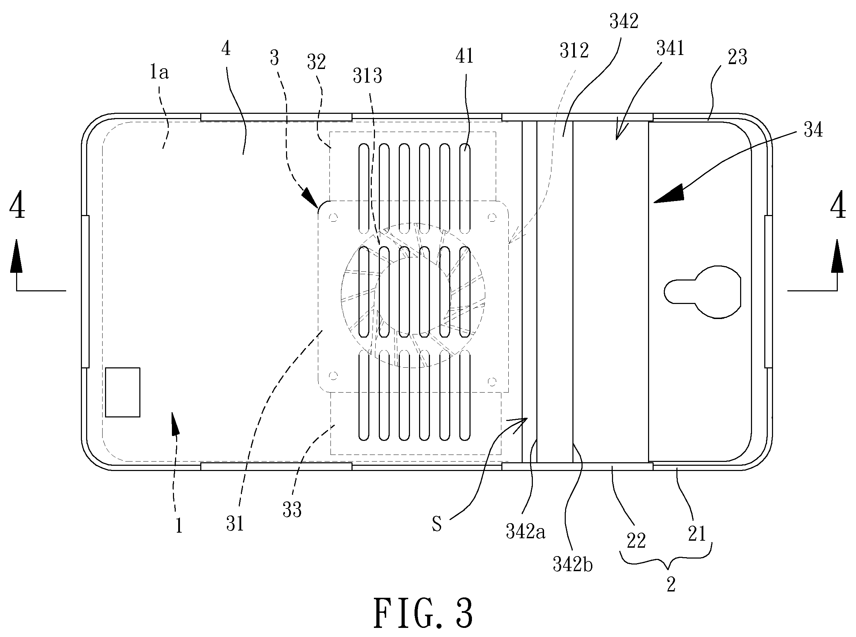

FIGS. 2 and 3 show a protective cover for a hand-held electronic device partly according to the present invention. The protective cover includes a base 1, a positioning member 2, and a cooling module 3. The positioning member 2 is provided along a periphery of the base 1 such that the protective cover can be coupled to a hand-held electronic device E. The cooling module 3 is mounted to an inner side of the base 1. When the cooling module 3 operates, air currents are drawn to flow into and out of the base 1 to assist in cooling of the hand-held electronic device E. The base 1 and the positioning member 2 can be made of materials with excellent elasticity, such as rubber, silicon rubber, or resins. Alternatively, the base 1 and the positioning member 2 can be made of rigid materials, such as metal or plastics.

The base 1 includes an inner face 1a and an outer face 1b opposite to the inner face 1a. The base 1 is associated with a back board of the hand-held electronic device E. The inner face 1a of the base 1 faces the back board of the hand-held electronic device E when the protective cover is mounted to the hand-held electronic device E. The base 1 further includes at least one air guiding hole 11 extending from the inner face 1a through the outer face 1b such that a space between the base 1 and the hand-held electronic device E can intercommunicate with the outside. The number, size, and shape of the at least one air guiding hole 11 are not limited. The design pattern of the at least one air guiding hole 11 can be changed to provide enhanced ornamental effect for the protective cover. Furthermore, the base 1 can include openings according to the locations of a camera, speaker, or buttons of the hand-held electronic device E, which can be appreciated by one having ordinary skill in the art. Thus, the base 1 is not limited to the form shown in the drawings.

The positioning member 2 is provided along the periphery of the base 1, with the periphery of the base 1 extending between the inner face 1a and the outer face 1b for coupling with the hand-held electronic device E. As an example, when the positioning member 2 is made of a material with excellent elasticity, the positioning member 2 can be an annular wall along the periphery of the base 1, and an inner periphery of the annular wall is contiguous to the inner face 1a of the base 1. Furthermore, the positioning member 2 can include an inwardly extending hook on a free end edge thereof to enhance the coupling with the hand-held electronic device E. If the positioning member 2 is made of a more rigid material, the positioning member 2 can be a plurality of hooks along the periphery of the base 1. Each hook has an inner periphery contiguous to the inner face 1a of the base 1. In the form shown, the positioning member 2 is an annular wall 21 on the periphery of the base 1, and the inner periphery of the annular wall 21 is contiguous to the inner face 1a of the base 1. Furthermore, a plurality of auxiliary positioning portions 22 is provided on the free end edge of the positioning member 2. Thus, the positioning member 2 can be securely coupled to the hand-held electronic device E by the annular wall 21 enveloping an edge of the hand-held electronic device and by the auxiliary positioning portions 22 hooked to a front side of the hand-held electronic device.

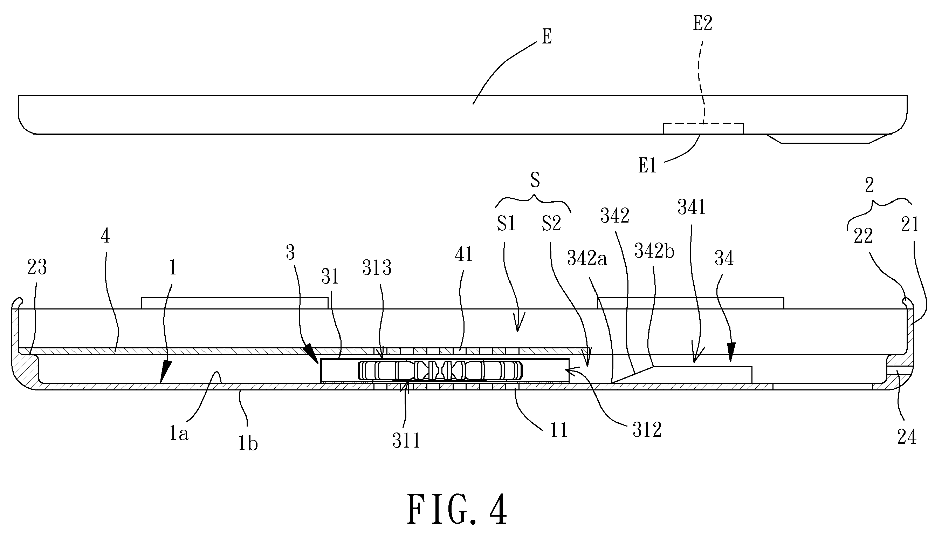

The positioning member 2 and the base 1 together define a receiving space S, with the inner face 1a of the base 1 facing the receiving space S for receiving the cooling module 3 and the hand-held electronic device E. The positioning member 2 can be coupled to the base 1 by any suitable provision or integrally formed with the base 1. With reference to FIG. 4, specifically, the receiving space S defined by the positioning member 2 and the base 1 includes an electronic device chamber S1 and a fan chamber S2. In this embodiment, the positioning member 2 includes an inner surface having a shoulder 23 extending in a first plane. The free end edge of the positioning member 2 extends in a second plane. The electronic device chamber S1 is defined between the first plane and the second plane. The hand-held electronic device E is received in the electronic device chamber S1, and the back board of the hand-held electronic device E abuts the shoulder 23. The fan chamber S2 is defined between the first plane and the inner face 1a of the base 1 and receives the cooling module 3. The fan chamber S2 and the electronic device chamber S1 overlap each other. Thus, the cooling module 3 and the hand-held electronic device E can be received in the receiving space S. Furthermore, the positioning member 2 includes at least one air discharge hole 24 intercommunicating the receiving space S with the outside. In a case that the positioning member 2 is in the form of an annular wall, the at least one air discharge hole 24 extends from an inner surface through an outer surface of the positioning member 2.

The cooling module 3 includes a cooling fan 31, a controller 32, a cell 33, and a flow guiding portion 34. The cooling fan 31, the controller 32, the cell 33, and the flow guiding portion 34 are fixed to the inner face 1a of the base 1 by any suitable provisions. The controller 32 is electrically connected to the cooling fan 31 and the cell 33. If cooling is desired, the cell 33 provides electricity to drive the cooling fan 31 to operate. The fan chamber S2 and the electronic device chamber S1 overlap in the axial direction of the cooling fan 31. The cooling fan 31 is received in the fan chamber S2 and is preferably aligned with or located adjacent to the at least one air guiding hole 11 of the base 1 to increase the cooling efficiency. Furthermore, the cooling fan 31 can be a centrifugal fan. The cooling fan 31 includes a main air inlet 311 in the axial direction. Preferably, the main air inlet 311 is aligned with and faces the at least one air guiding hole 11 of the base 1. Furthermore, the cooling fan 31 includes an air outlet 312 in a radial direction perpendicular to the axial direction. Preferably, the air outlet 312 faces the at least one air discharge hole 24 of the positioning member 2. The cell 33 can be a primary cell or secondary cell. Preferably, the cell 33 is a secondary cell such that the user can be charged from the outside of the protective cover when the electric energy stored in the cell 33 is running out. This avoids troublesome detachment of the protective cover for replacing the cell 33 and, thus, increases the use convenience.

In addition to receiving the cooling module 3, the fan chamber S2 can receive other electronic devices, such as a backup power, speaker, or flash light, providing additional functions. As an example, in a case that a backup power is received in the fan chamber S2, the backup power can be electrically connected to a cell in the hand-held electronic device E to charge the cell of the hand-held electronic device E. Alternatively, the backup power can be electrically connected to the cell 33 of the cooling module 3 to charge the cell 33. Furthermore, the backup power can be detached to allow easy removal from the fan chamber S2 by the user for charging purposes. When the cell of the hand-held electronic device E or the cell 33 of the cooling module 3 is running out of electricity, the backup power can be placed into the fan chamber S2 to supply electricity to the hand-held electronic device E or the cooling module 3. The backup power can serve as a conventional mobile power source and can be received in the fan chamber S2 without the disadvantage of occupying an additional space in the conventional mobile power source.

The flow guiding portion 34 is fixed to the inner face 1a of the base 1. Preferably, the flow guiding portion 34 adjoins the air outlet 312 of the cooling fan 31 such that the air output direction of the cooling fan 31 faces the flow guiding portion 34. Namely, the flow guiding portion 34 is located between the air outlet 312 and the at least one air discharge hole 24 of the positioning member 2. The flow guiding portion 34 includes a flow guiding face 341 having at least one non-parallel face 342 at a non-parallel angle to the inner face 1a. The at least one non-parallel face 342 can be a slant or a curved face. Namely, the non-parallel face 342 can be a slant at an acute angle to the inner face 1a or an arcuate, curved face. The present invention is not limited to the illustrated structure. Specifically, the non-parallel face 342 includes a first edge 342a adjoining the air outlet 312 and a second edge 342b distant from the air outlet 312. The non-parallel face 342 extends from the first edge 342a to the second edge 342b. A spacing between the first edge 342a and the inner face 1a in the axial direction is smaller than a spacing between the second edge 342b and the inner face 1a in the axial direction. By this arrangement, the air currents blown out from the air outlet 312 of the cooling fan 31 can be guided.

The protective cover can further include a spacer plate 4 to protect the cooling module 3 from damage. The spacer plate 4 abuts the shoulder 23 to cover the cooling module 3, particularly the cooling fan 31 and the controller 32. Thus, unintentional damage resulting from pressing on the cooling module 3 can be avoided when the user is mounting the protective cover. Note that when a spacer plate 4 is provided in the protective cover, since a side of the spacer plate 4 abuts the shoulder 23, the hand-held electronic device contacts the other side of the spacer plate 4 without contacting the shoulder 23.

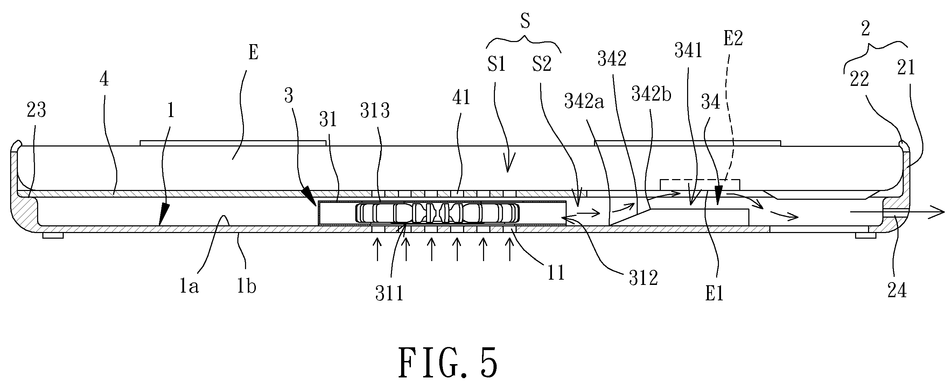

FIG. 5 shows use of the protective cover for a hand-held electronic device.

As mentioned above, the protective cover according to the present invention can be mounted to a hand-held electronic device E. When the cooling fan 31 of the cooling module 3 operates to guide the air currents in the receiving space S to the outside by passing through the at least one air discharge hole 24 of the positioning member 2, creating a negative pressure in the receiving space S which guides ambient air currents to flow into the receiving space S via the at least one air guiding hole 11 of the base 1. Thus, the low-temperature air outside of the protective cover can flow into the receiving space S via the main air inlet 311 of the cooling fan 31 to discharge the high-temperature air currents generated by the hand-held electronic device E out of the receiving space S, increasing the cooling efficiency of the hand-held electronic device E. Thus, the protective cover according to the present invention not only protects the hand-held electronic device E but increases the cooling efficiency of the hand-held electronic device E, avoiding overheating of the hand-held electronic device E during operation.

Furthermore, to meet the end of miniaturization of the protective cover of the present invention, the air outlet 312 of the cooling fan 31 cannot directly face the hand-held electronic device E. Nevertheless, by providing the flow guiding portion 34, the air currents blown out of the air outlet 312 can be guided by the flow guiding face 341, flow from the first edge 342a to the second edge 342b of the at least one non-parallel face 342, and directly flow towards a specific area of the back plate of the hand-held electronic device E, assuring an ideal cooling effect of the protective cover according to the present invention. Specifically, the back plate of the hand-held electronic device E has an area E1, and the heat sources E2 of the hand-held electronic device E are located adjacent to the area E1. Preferably, the area E1 is aligned with the flow guiding portion 34 in the axial direction of the cooling fan 31. By such an arrangement, the air currents blown out of the air outlet 312 are guided by the flow guiding face 341 to directly flow towards the area E1 and are then discharged via the at least one air discharge hole 24 of the positioning member 2, discharging the heat energy generated by the heat sources E2 such that the protective cover according to the present invention can achieve the optimal cooling efficiency.

Note that the cooling fan 31 of the cooling module 3 is preferably a centrifugal fan having two inlets. Namely, in addition to the main air inlet 311 in the axial direction, the cooling fan 31 further includes an auxiliary air inlet 313 aligned with the main air inlet 311 in the axial direction. Thus, the auxiliary air inlet 313 can be aligned with and face the hand-held electronic device E. By such an arrangement, when the cooling fan 31 operates, in addition to the main air inlet 311 drawing in the ambient air, the auxiliary air inlet 313 can draw in the air between the cooling fan 31 and the hand-held electronic device E, providing an auxiliary air intake effect. In a case that the spacer plate 4 also covers the cooling fan 31, the spacer plate 4 can include at least one through-hole 41 extending in the axial direction of the cooling fan 31 and aligned with the auxiliary air inlet 313, achieving an auxiliary air intake effect.

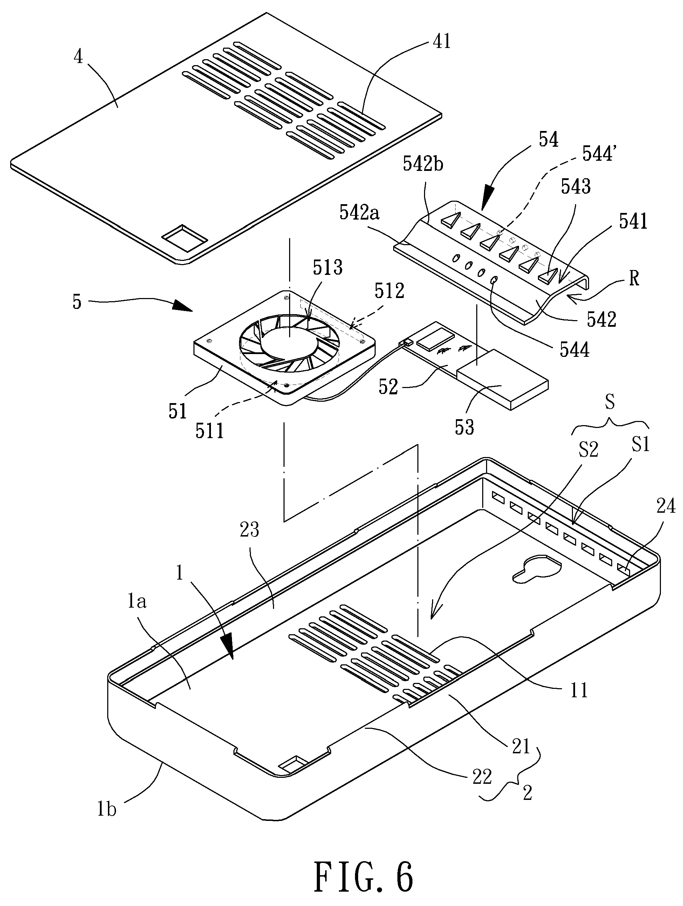

FIG. 6 shows a protective cover for a hand-held electronic device according to the present invention. The protective cover also includes a base 1, a positioning member 2, a cooling module 5, and a spacer plate 4. The base 1, the positioning member 2, and the spacer plate 4 are the same as those described above and, therefore, not described to avoid redundancy. The cooling module 5 of the invention also includes a fan 51, a controller 52, a cell 53, and a flow guiding portion 54. However, the flow guiding portion 54 further includes at least one spoiler 543. The at least one spoiler 543 can be a blocking member of any desired shape and is located on the flow guiding face 541 of the flow guiding portion 54 to provide a disturbing effect for the air currents flowing through the flow guiding face 541.

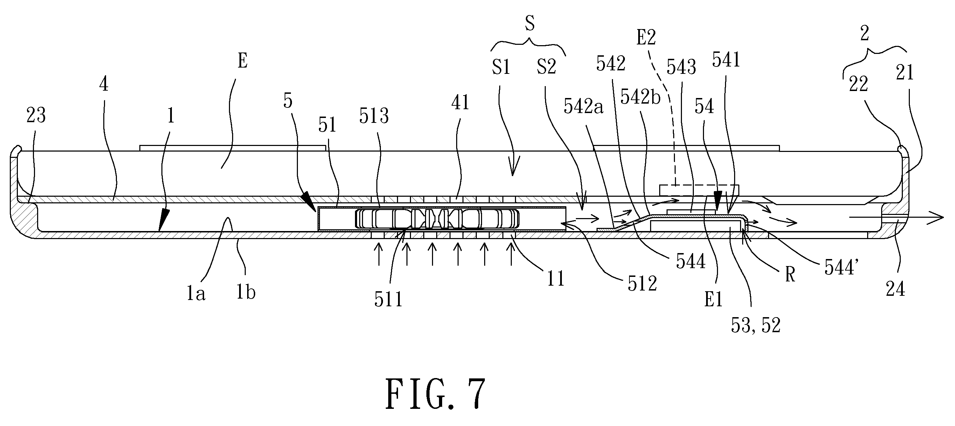

FIG. 7 illustrates use of the protective cover of the second embodiment according to the present invention. The area E1 is aligned with the flow guiding portion 54 of the cooling fan 51 in the axial direction of the cooling fan 51. Preferably, the area E1 is aligned with the at least one spoiler 543 on the flow guiding face 541. By such an arrangement, the air currents blown out of the air outlet 512 are guided by the flow guiding face 541 to flow from a first edge 542a to a second edge 542b of at least one non-parallel face 542 and, thus, directly flow towards the area E1. Furthermore, due to provision of the at least one spoiler 543 on the flow guiding face 541, the air currents flowing through the flow guiding face 541 can be stopped to change the flowing direction of the air currents through the disturbing effect. The proportion of the air currents directly flowing towards the area E1 is increased to effectively discharge the heat energy generated by the heat sources E2 adjacent to the area E1.

Furthermore, since controller 52 and the cell 53 of the cooling module 5 also generate heat, although the flow guiding portion 54 is also fixed to the inner face 1a of the base 1, a compartment R is defined between the flow guiding portion 54 and the inner face 1a, and the controller 52 and the cell 53 are received in the compartment R. Furthermore, the flow guiding face 541 of the flow guiding portion 54 further includes at least two through-holes 544 and 544' extending through the flow guiding face 541 and intercommunicating with the compartment R. One of the through-holes 544 is preferably aligned with the air outlet 512 of the cooling fan 51, and the other through-hole 544' is preferably aligned with the at least one air discharge hole 24 of the positioning member 2.

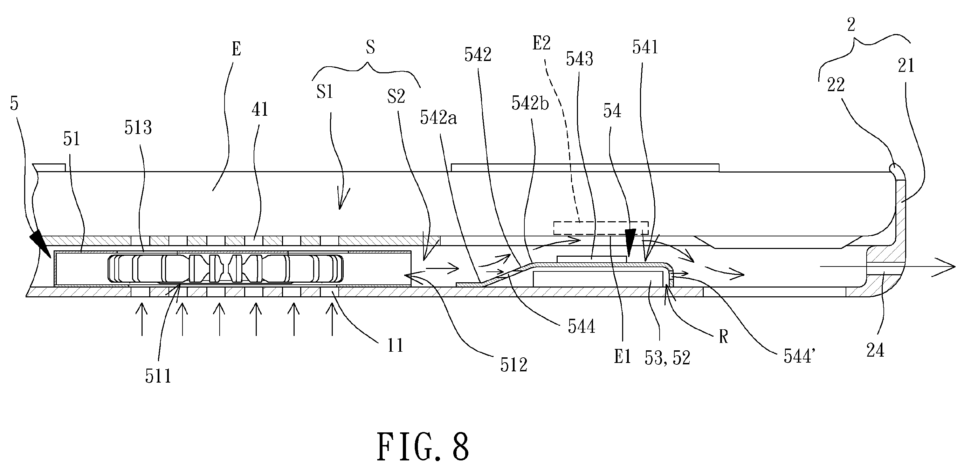

FIG. 8 illustrates a portion of the protective cover according to the present invention in use. By the provision of the at least two through-holes 544 and 544' in the flow guiding face 541 of the flow guiding portion 54, a portion of the air currents blown out of the air outlet 512 of the cooling fan 51 flows through the through-hole 544 into the compartment R, passes through the through-hole 544', and is then discharged via at the least one air discharge hole 24 of the positioning member 2. The heat energy generated by the controller 52 and the cell 53 is, thus, discharged.

By such an arrangement, the air currents generated by the cooling fan 51 of the cooling module 5 according to the present invention blown out of the air outlet 512 are guided by the flow guiding face 541 of the flow guiding portion 54 and are disturbed by the at least one spoiler 543 to effectively increase the contact area with the hand-held electronic device E and, thus, avoids the air currents from rapidly passing through its surface. Thus, the air currents directly flow towards the area E1 of the hand-held electronic device E to further increase the cooling effect. At the same time, a portion of the air currents is blown into the compartment R between the flow guiding portion 54 and the inner face 1a to carry away the waste heat generated by the controller 52 and the cell 53 in the compartment R, effectively reducing the operating temperature of the hand-held electronic device E to which the protective cover according to the present invention is coupled.

In view of the foregoing, the protective cover for a hand-held electronic device according to the present invention includes a cooling module 3, 5 having a cooling fan 31, 51 to provide an auxiliary cooling function in addition to the basic functions of protection and ornamentation, increasing the cooling efficiency of the hand-held electronic device E in operation.

Furthermore, in the protective cover for a hand-held electronic device according to the present invention, the flow guiding portion 34, 54 of the cooling module 3, 5 is located at the air outlet 312, 512 of the cooling fan 31, 51 to guide the air currents blown out by the cooling fan 31, 51 to directly flow towards the hand-held electronic device E, assuring an ideal cooling effect of the protective cover.

Furthermore, the protective cover for a hand-held electronic device according to the present invention uses the controller 32, 52 and the cell 33, 53 to drive the cooling fan 31, 51 to rotate. Furthermore, the controller 52 and the cell 53 can be received in a compartment R such that the air currents blown out of the cooling fan 51 can also discharge the heat generated by the controller 52 and the cell 53, reducing the operating temperature of the hand-held electronic device E.

Thus since the invention disclosed herein may be embodied in other specific forms without departing from the spirit or general characteristics thereof as disclosed in the claims, some of which forms have been indicated, the embodiments described herein are to be considered in all respects illustrative and not restrictive. The scope of the invention is indicated by the appended claims, rather than by the foregoing description, and all changes which come within the meaning and range of equivalency of the claims are intended to be embraced therein.

## Claims

1. A protective cover for a hand-held electronic device comprising:
a base (1) including an inner face (1a) and an outer face (1b) opposite to the inner face (1a), with the base (1) further including at least one air guiding hole (11) extending from the inner face (1a) through the outer face (1b), and with the base (1) further including a periphery extending between the inner face (1a) and the outer face (1b);
a positioning member (2) provided along the periphery of the base (1), with the positioning member (2) and the base (1) together defining a receiving space (S);
a cooling module (3, 5) mounted in the receiving space (S), with the cooling module (3, 5) including a cooling fan (31, 51) and a flow guiding portion (34, 54), with the cooling fan (31, 51) and the flow guiding portion (34, 54) fixed to the inner face (1a) of the base (1), with the cooling fan (31, 51) including an air outlet (312, 512) adjoining the flow guiding portion (34, 54), with the flow guiding portion (34, 54) including a flow guiding face (341, 541) having at least one non-parallel face (342, 542) at a non-parallel angle to the inner face (1a);
wherein the protective cover is **characterized in that**
the flow guiding portion (34, 54) further includes at least one spoiler (543) on the flow guiding face (341, 541).

2. The protective cover for a hand-held electronic device as claimed in claim 1, **characterized in that** the non-parallel face (342, 542) is a slant at an acute angle to the inner face (1a).

3. The protective cover for a hand-held electronic device as claimed in claim 1, **characterized in that** the non-parallel face (342, 542) is an arcuate, curved face.

4. The protective cover for a hand-held electronic device as claimed in claim 1, **characterized in that** the non-parallel face (342, 542) includes a first edge (342a, 542a) adjoining the air outlet (312, 512) and a second edge (342b, 542b) distant from the air outlet (312, 512), with the non-parallel face (342, 542) extending from the first edge (342a, 542a) to the second edge (342b, 542b), and with a spacing between the first edge (342a, 542a) and the inner face (1a) smaller than a spacing between the second edge (342b, 542b) and the inner face (1a).

5. The protective cover for a hand-held electronic device as claimed in claim 1, **characterized in that** the cooling fan (31, 51) is aligned with or located adjacent to the at least one air guiding hole (11) of the base (1).

6. The protective cover for a hand-held electronic device as claimed in claim 1, **characterized in that** the positioning member (2) includes at least one air discharge hole (24) intercommunicating the receiving space (S) with an outside.

7. The protective cover for a hand-held electronic device as claimed in claim 6, **characterized in that** the cooling fan (31, 51) is a centrifugal fan, with the cooling fan (31, 51) including a main air inlet (311, 511) in an axial direction thereof, with the main air inlet (311, 511) aligned with and facing the at least one air guiding hole (11) of the base (1), with the air outlet (312, 512) of the cooling fan (31, 51) located in a radial direction of the cooling fan (31, 51) perpendicular to the axial direction, and with the air outlet (312, 512) facing the at least one air discharge hole (24) of the positioning member (2).

8. The protective cover for a hand-held electronic device as claimed in claim 1, **characterized in that** the cooling module (3, 5) further includes a controller (32, 52) and a cell (33, 53), with the controller (32, 52) and the cell (33, 53) fixed to the inner face (1a) of the base (1), and with the controller (32, 52) electrically connected to the cooling fan (31, 51) and the cell (33, 53).

9. The protective cover for a hand-held electronic device as claimed in claim 8, **characterized in that** a compartment (R) is defined between the flow guiding portion (34, 54) and the inner face (1a), with the controller (32, 52) and the cell (33, 53) received in the compartment (R).

10. The protective cover for a hand-held electronic device as claimed in claim 9, **characterized in that** the flow guiding face (341, 541) of the flow guiding portion (34, 54) further includes at least two through-holes, with each of the at least two through-holes extending through the flow guiding face (341, 541) and intercommunicating with the compartment (R), with the at least two through-holes including two through-holes, with one of the two through-holes aligned with the air outlet (312, 512) of the cooling fan (31, 51), and with another of the two through-holes aligned with the at least one air discharge hole (24) of the positioning member (2).

11. The protective cover for a hand-held electronic device as claimed in claim 1, **characterized in that** the receiving space (S) includes an electronic device chamber (S1) and a fan chamber (S2), with the positioning member (2) including an inner surface having a shoulder (23) extending in a first plane, with the positioning member (2) further including a free end edge extending in a second plane, with the electronic device chamber (S1) defined between the first plane and the second plane, with the cooling module (3) received in the fan chamber (S2), and with the fan chamber (S2) and the electronic device chamber (S1) overlapped in the axial direction of the cooling fan (31, 51).

12. The protective cover for a hand-held electronic device as claimed in claim 8, **characterized in** further comprising: a spacer plate (4), with the spacer plate (4) abutting a shoulder (23) to cover the cooling fan (31, 51) and the controller (32, 52) of the cooling module (3).

13. The protective cover for a hand-held electronic device as claimed in claim 12, **characterized in that** the cooling fan (31, 51) further includes an auxiliary air inlet (313, 513) in the axial direction, with the auxiliary air inlet (313, 513) aligned with the main air inlet (311, 511) in the axial direction.

14. The protective cover for a hand-held electronic device as claimed in claim 13, **characterized in that** the spacer plate (4) includes at least one through-hole (41), with the at least one through-hole (41) extending in the axial direction of the cooling fan (31, 51) and aligned with the auxiliary air inlet (313, 513).

## Patentansprüche

1. Schutzhülle für eine tragbare elektronische Vorrichtung, die Folgendes umfasst:
ein Unterteil (1), das eine Innenfläche (1a) und eine Außenfläche (1 b), die der Innenfläche (1a) gegenüber liegt, enthält, wobei das Unterteil (1) ferner mindestens eine Luftleitöffnung (11) enthält, die sich von der Innenfläche (1a) bis zu der Außenfläche (1b) erstreckt, und wobei das Unterteil (1) ferner einen Rand enthält, der sich zwischen der Innenfläche (1a) und der Außenfläche (1b) erstreckt;
ein Positionierelement (2), das entlang des Randes des Unterteils (1) vorgesehen ist, wobei das Positionierelement (2) und das Unterteil (1) zusammen einen Aufnahmeraum (S) definieren;
ein Kühlmodul (3, 5), das in dem Aufnahmeraum (S) montiert ist, wobei das Kühlmodul (3, 5) einen Kühlventilator (31, 51) und einen Strömungsleitabschnitt (34, 54) enthält, wobei der Kühlventilator (31, 51) und der Strömungsleitabschnitt (34, 54) an der Innenfläche (1a) des Unterteils (1) befestigt sind, wobei der Kühlventilator (31, 51) einen Luftauslass (312, 512) enthält, der an den Strömungsleitabschnitt (34, 54) angrenzt, wobei der Strömungsleitabschnitt (34, 54) eine Strömungsleitfläche (341, 541) enthält, die mindestens eine nicht parallele Fläche (342, 542) unter einem nicht parallelen Winkel zur Innenfläche (1a) aufweist;
wobei die Schutzhülle **dadurch gekennzeichnet ist, dass**
der Strömungsleitabschnitt (34, 54) auf der Strömungsleitfläche (341, 541) ferner mindestens einen Spoiler (543) enthält.

2. Schutzhülle für eine tragbare elektronische Vorrichtung nach Anspruch 1, **dadurch gekennzeichnet, dass** die nicht parallele Fläche (342, 542) eine Abschrägung mit einem spitzen Winkel zur Innenfläche (1a) ist.

3. Schutzhülle für eine tragbare elektronische Vorrichtung nach Anspruch 1, **dadurch gekennzeichnet, dass** die nicht parallele Fläche (342, 542) eine bogenförmige, gekrümmte Fläche ist.

4. Schutzhülle für eine tragbare elektronische Vorrichtung nach Anspruch 1, **dadurch gekennzeichnet, dass** die nicht parallele Fläche (342, 542) eine erste Kante (342a, 542a), die an den Luftauslass (312, 512) angrenzt, und eine zweite Kante (342b, 542b), die von dem Luftauslass (312, 512) entfernt liegt, umfasst, wobei sich die nicht parallele Fläche (342, 542) von der ersten Kante (342a, 542a) zu der zweiten Kante (342b, 542b) erstreckt und wobei ein Abstand zwischen der ersten Kante (342a, 542a) und der Innenfläche (1a) kleiner ist als ein Abstand zwischen der zweiten Kante (342b, 542b) und der Innenfläche (1a).

5. Schutzhülle für eine tragbare elektronische Vorrichtung nach Anspruch 1, **dadurch gekennzeichnet, dass** der Kühlventilator (31, 51) auf die mindestens eine Luftleitöffnung (11) des Unterteils (1) ausgerichtet ist oder neben der mindestens einen Luftleitöffnung (11) des Unterteils (1) positioniert ist.

6. Schutzhülle für eine tragbare elektronische Vorrichtung nach Anspruch 1, **dadurch gekennzeichnet, dass** das Positionierelement (2) mindestens eine Luftauslassöffnung (24) enthält, die den Aufnahmeraum (S) mit einer Außenseite verbindet.

7. Schutzhülle für eine tragbare elektronische Vorrichtung nach Anspruch 6, **dadurch gekennzeichnet, dass** der Kühlventilator (31, 51) einem Radialventilator entspricht, wobei der Kühlventilator (31, 51) in seiner Achsrichtung einen Hauptlufteinlass (311, 511) aufweist, wobei der Hauptlufteinlass (311, 511) auf die mindestens eine Luftleitöffnung (11) des Unterteils (1) ausgerichtet ist und der mindestens einen Luftleitöffnung (11) des Unterteils (1) gegenüberliegt, wobei der Luftauslass (312, 512) des Kühlventilators (31, 51) in einer radialen Richtung des Kühlventilators (31, 51) senkrecht zu der Achsrichtung positioniert ist und wobei der Luftauslass (312, 512) der mindestens einen Luftauslassöffnung (24) des Positionierelements (2) gegenüberliegt.

8. Schutzhülle für eine tragbare elektronische Vorrichtung nach Anspruch 1, **dadurch gekennzeichnet, dass** das Kühlmodul (3, 5) ferner eine Steuerung (32, 52) und eine Zelle (33, 53) enthält, wobei die Steuerung (32, 52) und die Zelle (33, 53) an der Innenfläche (1a) des Unterteils (1) befestigt sind und wobei die Steuerung (32, 52) mit dem Kühlventilator (31, 51) und der Zelle (33, 53) elektrisch verbunden ist.

9. Schutzhülle für eine tragbare elektronische Vorrichtung nach Anspruch 8, **dadurch gekennzeichnet, dass** ein Raum (R) zwischen dem Strömungsleitabschnitt (34, 54) und der Innenfläche (1a) definiert ist, wobei die Steuerung (32, 52) und die Zelle (33, 53) in dem Raum (R) aufgenommen sind.

10. Schutzhülle für eine tragbare elektronische Vorrichtung nach Anspruch 9, **dadurch gekennzeichnet, dass** die Strömungsleitfläche (341, 541) des Strömungsleitabschnitts (34, 54) ferner mindestens zwei Durchgangslöcher enthält, wobei sich jedes der mindestens zwei Durchgangslöcher durch die Strömungsleitfläche (341, 541) erstreckt und mit dem Raum (R) kommuniziert, wobei die mindestens zwei Durchgangslöcher zwei Durchgangslöcher enthalten, wobei eines der zwei Durchgangslöcher auf den Luftauslass (312, 512) des Kühlventilators (31, 51) ausgerichtet ist und wobei ein anderes der zwei Durchgangslöcher auf die mindestens eine Luftauslassöffnung (24) des Positionierelements (2) ausgerichtet ist.

11. Schutzhülle für eine tragbare elektronische Vorrichtung nach Anspruch 1, **dadurch gekennzeichnet, dass** der Aufnahmeraum (S) eine Kammer (S1) für die elektronische Vorrichtung und eine Ventilatorkammer (S2) enthält, wobei das Positionierelement (2) eine innere Oberfläche enthält, die eine Schulter (23) aufweist, die sich in einer ersten Ebene erstreckt, wobei das Positionierelement (2) ferner eine freie Endkante enthält, die sich in einer zweiten Ebene erstreckt, wobei die Kammer für die elektronische Vorrichtung (S1) zwischen der ersten Ebene und der zweiten Ebene definiert ist, wobei das Kühlmodul (3) in der Ventilatorkammer (S2) aufgenommen ist und wobei die Ventilatorkammer (S2) und die Kammer (S1) für die elektronische Vorrichtung in der Achsrichtung des Kühlventilators (31, 51) überlappen.

12. Schutzhülle für eine tragbare elektronische Vorrichtung nach Anspruch 8, **dadurch gekennzeichnet, dass** sie ferner Folgendes umfasst: eine Abstandsplatte (4), wobei die Abstandsplatte (4) an eine Schulter (23) anstößt, um den Kühlventilator (31, 51) und die Steuerung (32, 52) des Kühlmoduls (3) abzudecken.

13. Schutzhülle für eine tragbare elektronische Vorrichtung nach Anspruch 12, **dadurch gekennzeichnet, dass** der Kühlventilator (31, 51) ferner in der Achsrichtung einen Hilfslufteinlass (313, 513) enthält, wobei der Hilfslufteinlass (313, 513) in der Achsrichtung auf den Hauptlufteinlass (311, 511) ausgerichtet ist.

14. Schutzhülle für eine tragbare elektronische Vorrichtung nach Anspruch 13, **dadurch gekennzeichnet, dass** die Abstandsplatte (4) mindestens ein Durchgangsloch (41) enthält, wobei sich das mindestens eine Durchgangsloch (41) in der Achsrichtung des Kühlventilators (31, 51) erstreckt und auf den Hilfslufteinlass (313, 513) ausgerichtet ist.

## Revendications

1. Couvercle de protection pour un dispositif électronique portable comprenant :
une base (1) comprenant une face interne (1a) et une face externe (1b) opposée à la face interne (1a), avec la base (1) qui comprend en outre au moins un trou de guidage d'air (11) s'étendant à partir de la face interne (1a) en passant par la face externe (1b), et avec la base (1) qui comprend en outre une périphérie s'étendant entre la face interne (1a) et la face externe (1b) ;
un élément de positionnement (2) prévu le long de la périphérie de la base (1), avec l'élément de positionnement (2) et la base (1) qui définissent ensemble un espace de réception (S) ;
un module de refroidissement (3, 5) monté dans l'espace de réception (S), avec le module de refroidissement (3, 5) qui comprend un ventilateur de refroidissement (31, 51) et une partie de guidage d'écoulement (34, 54), avec le ventilateur de refroidissement (31, 51) et la partie de guidage d'écoulement (34, 54) fixés à la face interne (1a) de la base (1), avec le ventilateur de refroidissement (31, 51) qui comprend une sortie d'air (312, 512) attenante à la partie de guidage d'écoulement (34, 54), avec la partie de guidage d'écoulement (34, 54) qui comprend une face de guidage d'écoulement (341, 541) ayant au moins une face non parallèle (342, 542) à un angle non parallèle à la face interne (1a) ;
dans lequel le couvercle de protection est **caractérisé en ce que** :
la partie de guidage d'écoulement (34, 54) comprend en outre au moins un déflecteur (543) sur la face de guidage d'écoulement (341, 541).

2. Couvercle de protection pour un dispositif électronique portable selon la revendication 1, **caractérisé en ce que** la face non parallèle (342, 542) est inclinée à un angle aigu par rapport à la face interne (1a).

3. Couvercle de protection pour un dispositif électronique portable selon la revendication 1, **caractérisé en ce que** la face non parallèle (342, 542) est une face incurvée arquée.

4. Couvercle de protection pour un dispositif électronique portable selon la revendication 1, **caractérisé en ce que** la face non parallèle (342, 542) comprend un premier bord (342a, 542a) attenant à la sortie d'air (312, 512) et un second bord (342b, 542b) distant de la sortie d'air (312, 512), avec la face non parallèle (342, 542) qui s'étend du premier bord (342a, 542a) au second bord (342b, 542b), et avec un espacement entre le premier bord (342a, 542a) et la face interne (1a) qui est inférieur à un espacement entre le second bord (342b, 542b) et la face interne (1a).

5. Couvercle de protection pour un dispositif électronique portable selon la revendication 1, **caractérisé en ce que** le ventilateur de refroidissement (31, 51) est aligné avec ou positionné de manière adjacente au au moins un trou de guidage d'air (11) de la base (1).

6. Couvercle de protection pour un dispositif électronique portable selon la revendication 1, **caractérisé en ce que** l'élément de positionnement (2) comprend au moins un trou de décharge d'air (24) faisant communiquer l'espace de réception (S) avec un extérieur.

7. Couvercle de protection pour un dispositif électronique portable selon la revendication 6, **caractérisé en ce que** le ventilateur de refroidissement (31, 51) est un ventilateur centrifuge, avec le ventilateur de refroidissement (31, 51) qui comprend une entrée d'air principale (311, 511) dans sa direction axiale, avec l'entrée d'air principale (311, 511) alignée avec et faisant face au au moins un trou de guidage d'air (11) de la base (1), avec la sortie d'air (312, 512) du ventilateur de refroidissement (31, 51) positionnée dans une direction radiale du ventilateur de refroidissement (31, 51) perpendiculaire à la direction axiale, et avec la sortie d'air (312, 512) faisant face au au moins un trou de décharge d'air (24) de l'élément de positionnement (2).

8. Couvercle de protection pour un dispositif électronique portable selon la revendication 1, **caractérisé en ce que** le module de refroidissement (3, 5) comprend en outre un organe de commande (32, 52) et une cellule (33, 53), avec l'organe de commande (32, 52) et la cellule (33, 53) fixés à la face interne (1a) de la base (1), et avec l'organe de commande (32, 52) électriquement raccordé au ventilateur de refroidissement (31, 51) et à la cellule (33, 53).

9. Couvercle de protection pour un dispositif électronique portable selon la revendication 8, **caractérisé en ce qu'**un compartiment (R) est défini entre la partie de guidage d'écoulement (34, 54) et la face interne (1a), avec l'organe de commande (32, 52) et la cellule (33, 53) reçus dans le compartiment (R).

10. Couvercle de protection pour un dispositif électronique portable selon la revendication 9, **caractérisé en ce que** la face de guidage d'écoulement (341, 541) de la partie de guidage d'écoulement (34, 54) comprend en outre au moins deux trous débouchants, avec chacun des au moins deux trous débouchants qui s'étend à travers la face de guidage d'écoulement (341, 541) et communiquant avec le compartiment (R), avec les au moins deux trous débouchants qui comprennent deux trous débouchants, avec l'un des deux trous débouchants aligné avec la sortie d'air (312, 512) du ventilateur de refroidissement (31, 51) et avec un autre des deux trous débouchants aligné avec le au moins un trou de décharge d'air (24) de l'élément de positionnement (2).

11. Couvercle de protection pour un dispositif électronique portable selon la revendication 1, **caractérisé en ce que** l'espace de réception (S) comprend une chambre de dispositif électronique (S1) et une chambre de ventilateur (S2), avec l'élément de positionnement (2) qui comprend une surface interne ayant un épaulement (23) s'étendant dans un premier plan, avec l'élément de positionnement (2) qui comprend un bord d'extrémité libre s'étendant dans un second plan, avec la chambre de dispositif électronique (S1) définie entre le premier plan et et le second plan, avec le module de refroidissement (3) reçu dans la chambre de ventilateur (S2), et avec la chambre de ventilateur (S2) et la chambre de dispositif électronique (S1) qui chevauchent dans la direction axiale du ventilateur de refroidissement (31, 51).

12. Couvercle de protection pour un dispositif électronique portable selon la revendication 8, **caractérisé en ce qu'**il comprend en outre : une plaque d'espacement (4), avec la plaque d'espacement (4) qui vient en butée contre un épaulement (23) pour recouvrir le ventilateur de refroidissement (31, 51) et l'organe de commande (32, 52) du module de refroidissement (3).

13. Couvercle de protection pour un dispositif électronique portable selon la revendication 12, **caractérisé en ce que** le ventilateur de refroidissement (31, 51) comprend en outre une entrée d'air auxiliaire (313, 513) dans la direction axiale, avec l'entrée d'air auxiliaire (313, 513) alignée avec l'entrée d'air principale (311, 511) dans la direction axiale.

14. Couvercle de protection pour un dispositif électronique portable selon la revendication 13, **caractérisé en ce que** le plaque d'espacement (4) comprend au moins un trou débouchant (41), avec le au moins un trou débouchant (41) qui s'étend dans la direction axiale du ventilateur de refroidissement (31, 51) et aligné avec l'entrée d'air auxiliaire (313, 513).
